(19) **Europäisches Patentamt / European Patent Office / Office européen des brevets**

(11) **EP 3 683 049 A1**

(12) **EUROPEAN PATENT APPLICATION**
published in accordance with Art. 153(4) EPC

(43) Date of publication:
**22.07.2020 Bulletin 2020/30**

(51) Int Cl.:
***B32B 9/00*** (2006.01)

(21) Application number: **18855775.5**

(22) Date of filing: **10.09.2018**

(86) International application number:
**PCT/JP2018/033393**

(87) International publication number:
**WO 2019/054318 (21.03.2019 Gazette 2019/12)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **13.09.2017 JP 2017175616**

(71) Applicant: **Sumitomo Chemical Company Limited Tokyo 104-8260 (JP)**

(72) Inventors:
• **LI, Guan**
  **Tsukuba-shi**
  **Ibaraki 300-3294 (JP)**

• **OZEKI, Miho**
  **Tsukuba-shi**
  **Ibaraki 300-3294 (JP)**
• **YAMASHITA, Yasuhiro**
  **Tsukuba-shi**
  **Ibaraki 300-3294 (JP)**
• **HANAOKA, Hidenori**
  **Osaka-shi**
  **Osaka 554-8558 (JP)**

(74) Representative: **J A Kemp LLP**
  **14 South Square**
  **Gray's Inn**
  **London WC1R 5JJ (GB)**

(54) **GAS BARRIER FILM AND FLEXIBLE ELECTRONIC DEVICE**

(57) An object of the present invention is to provide a gas barrier film which exhibits excellent gas barrier property and flexibility and suppresses the decreases in adhesive property between layers and optical properties under high humidity conditions. A gas barrier film including at least a substrate layer including at least a flexible substrate, an undercoat layer, and an inorganic thin film layer in this order, in which a water vapor transmission rate through the gas barrier film at 23°C and 50% RH is 0.001 g/m$^2$/day or less and a number of durability N measured by performing a steel wool test of an outermost surface on an inorganic thin film layer side of the gas barrier film using #0000 steel wool under conditions of a load of 50 gf/cm$^2$, a speed of 60 rpm/min, and a one-way distance of 3 cm satisfies Formula (1):

$$N \leq 200 \quad (1).$$

Fig. 5

**Description**

TECHNICAL FIELD

The present invention relates to a gas barrier film and a flexible electronic device including the gas barrier film.

BACKGROUND ART

Gas barrier films are widely used in packaging applications of foods, industrial supplies, pharmaceuticals and the like. In recent years, flexible substrates for electronic devices such as solar cells and organic EL displays and the like, there is a demand for films exhibiting further improved gas barrier property as compared with the films for food applications and the like. In order to enhance the performance, such as gas barrier property and flexibility, of gas barrier films, the configurations and manufacturing methods of gas barrier films have been variously investigated.

For example, Patent Document 1 describes a gas barrier film in which a resin substrate, a stress absorbing layer provided on both surfaces of the resin substrate, and a gas barrier layer provided at least on one surface of the stress absorbing layer are laminated.

Patent Document 2 describes a gas barrier film including a substrate, an undercoat layer disposed on one surface of the substrate, a barrier layer disposed on the undercoat layer, and a hard coat layer disposed on a surface on the opposite side to the surface on which the undercoat layer is disposed of the substrate.

Patent Document 3 describes a laminated film including a flexible substrate, an organic layer provided to be in contact with at least one surface of the substrate, and a thin film layer provided to be in contact with the organic layer.

PRIOR ART DOCUMENTS

PATENT DOCUMENTS

Patent Document 1: JP-A-2014-83690
Patent Document 2: WO 2016/043141 A
Patent Document 3: JP-A-2016-68383

SUMMARY OF THE INVENTION

PROBLEMS TO BE SOLVED BY THE INVENTION

It has been various attempted to achieve both gas barrier property and flexibility, but in conventional gas barrier films, it cannot be said that the adhesive property between the respective layers is sufficient and there has been a case in which peeling off of layers from each other occurs when a device including a gas barrier film is used particularly under high humidity conditions. In addition, there has been a case in which the film is whitened and the optical properties cannot be maintained when a device including a gas barrier film is used particularly under high humidity conditions. None of the films described in Patent Documents 1 to 3 pays attention to the adhesive property between layers and optical properties after use under high humidity conditions.

Hence, an object of the present invention is to provide a gas barrier film which exhibits excellent gas barrier property and flexibility and suppresses the decreases in adhesive property between layers and optical properties under high humidity conditions.

MEANS FOR SOLVING THE PROBLEMS

The present inventors have intensively investigated the configurations of gas barrier films in detail to achieve the object and thus completed the present invention.

In other words, the present invention includes the following suitable aspects.

[1] A gas barrier film including at least a substrate layer including at least a flexible substrate, an undercoat layer, and an inorganic thin film layer in this order, in which

a water vapor transmission rate through the gas barrier film at 23°C and 50% RH is 0.001 $g/m^2/day$ or less, and
a number of durability N measured by performing a steel wool test of an outermost surface on an inorganic thin film layer side of the gas barrier film using #0000 steel wool under conditions of a load of 50 gf/cm$^2$, a speed of 60 rpm/min, and a one-way distance of 3 cm satisfies Formula (1):

$$N \leq 200 \quad (1).$$

[2] The gas barrier film according to [1], in which the undercoat layer contains a polymer of a photocurable compound having a polymerizable functional group.

[3] The gas barrier film according to [1] or [2], in which a coefficient of dynamic friction between one outermost surface and the other outermost surface of the gas barrier film is 0.5 or less.

[4] The gas barrier film according to any one of [1] to [3], in which $I_a$ and $I_b$ satisfy Formula (2) :

$$0.05 \leq I_b/I_a \leq 1.0 \quad (2),$$

where $I_a$ denotes an intensity of an infrared absorption peak in a range of 1,000 to 1,100 cm$^{-1}$ in an infrared absorption spectrum of the undercoat layer and $I_b$ denotes an intensity of an infrared absorption peak in a range of 1,700 to 1,800 cm$^{-1}$.

[5] The gas barrier film according to any one of [1] to [4], in which the inorganic thin film layer contains at least a silicon atom, an oxygen atom, and a carbon atom.

[6] The gas barrier film according to [5], in which a ratio of a number of carbon atom to a total number of silicon atom, oxygen atom, and carbon atom contained in the inorganic thin film layer continuously changes in 90% or more of region in a film thickness direction of the inorganic thin film layer.

[7] The gas barrier film according to [5] or [6], in which a carbon distribution curve indicating relationship between a distance from a surface of the inorganic thin film layer in the film thickness direction of the inorganic thin film layer and a ratio of a number of carbon atom to a total number of silicon atom, oxygen atom, and carbon atom contained in the inorganic thin film layer at each distance has eight or more extreme values.

[8] The gas barrier film according to any one of [1] to [7], including a protective thin film layer on the inorganic thin film layer, in which the protective thin film layer is fabricated by subjecting a coating film obtained from a coating liquid containing a silicon compound to a modification treatment.

[9] A flexible electronic device including the gas barrier film according to any one of [1] to [8].

EFFECT OF THE INVENTION

According to the present invention, it is possible to provide a gas barrier film which exhibits excellent gas barrier property and flexibility and suppresses the decreases in adhesive property between layers and optical properties under high humidity conditions.

BRIEF DESCRIPTION OF THE DRAWINGS

Fig. 1 is a schematic sectional view illustrating an example of a gas barrier film of the present invention.
Fig. 2 is a schematic sectional view illustrating another example of a gas barrier film of the present invention.
Fig. 3 is a schematic sectional view illustrating still another example of a gas barrier film of the present invention.
Fig. 4 is a schematic sectional view illustrating yet another example of a gas barrier film of the present invention.
Fig. 5 is a schematic view illustrating an apparatus for manufacturing a gas barrier film used in Examples and Comparative Examples.

MODE FOR CARRYING OUT THE INVENTION

Hereinafter, embodiments of the present invention will be described in detail. It should be noted that the scope of the present invention is not limited to the embodiments described here and various changes can be made without departing from the gist of the present invention.

[Gas barrier film]

The gas barrier film of the present invention includes at least a substrate layer including at least a flexible substrate, an undercoat layer, and an inorganic thin film layer in this order.

The water vapor transmission rate through the gas barrier film of the present invention at 23°C and 50% RH is 0.001 g/m$^2$/day or less. In a case in which the water vapor transmission rate at 23°C and 50% RH is more than 0.001 g/m$^2$/day, it is impossible to sufficiently prevent transmission of water vapor in a case in which the gas barrier film is used as a flexible substrate of an electronic device and the like. The water vapor transmission rate is preferably 0.0001 g/m$^2$/day or less and more preferably 0.00001 g/m$^2$/day or less from the viewpoint of further enhancing the gas barrier property. It is more preferable as the water vapor transmission rate is lower, and the lower limit of the water vapor transmission rate is not particularly limited and is usually 0 g/m$^2$/day or more. Here, the water vapor transmission rate can be measured by a Ca corrosion testing method in conformity with ISO/WD 15106-7 (Annex C).

Examples of a method for adjusting the water vapor transmission rate through the gas barrier film to the range include a method in which the thickness of the inorganic thin film layer is adjusted and a method in which the flatness of the undercoat layer is adjusted.

The number of durability N measured by performing a steel wool test of the outermost surface on the inorganic thin film layer side of the gas barrier film of the present invention using #0000 steel wool under conditions of a load of 50 gf/cm$^2$, a speed of 60 rpm/min, and a one-way distance of 3 cm satisfies Formula (1):

$N \leq 200$ (1). In a case in which the number of durability N is more than 200 times, the hardness of the outermost surface on the inorganic thin film layer side increases too high and thus the adhesive property between layers under a high humidity condition decreases. The fact that the hardness of the outermost surface on the inorganic thin film layer side is high is considered to indicate that the inorganic thin film layer and/or the undercoat layer are hard. For this reason, it is considered that the adhesive property between these two layers is not attained and a gap and the like are generated between the layers under a high humidity condition. Incidentally, it is considered that the fact that the proportion of C=O double bond to the siloxane-derived Si-O-Si bond in the undercoat layer relatively increases too high is one factor of that the undercoat layer becomes too hard. Incidentally, the present invention is not limited to the mechanism at all. The number of durability N described above is preferably 200 times or less, more preferably 120 times or less, and still more preferably 70 times or less from the viewpoint of easily enhancing the adhesive property between layers under a high humidity condition.

The lower limit of the number of durability N measured on the outermost surface on the inorganic thin film layer side of the gas barrier film of the present invention in the same manner as described above is not particularly limited, and may be 0 time or more, but is preferably 10 times or more, more preferably 20 times or more, still more preferably 30 times or more, and particularly preferably 40 times or more from the viewpoint of easily adjusting the coefficient of dynamic friction to a preferable range. In a case in which the hardness of the outermost surface on the inorganic thin film layer side represented by the number of durability is too low, whitening occurs under a high humidity condition and the optical properties of the gas barrier film decrease in some cases. The fact that the number of durability is low is considered to indicate that the inorganic thin film layer and/or the undercoat layer is/are soft. In this case, it is considered that these layers easily absorb water under a high humidity condition and the water absorption causes whitening of the layers. Incidentally, the present invention is not limited to the mechanism at all. For this reason, the optical properties of the gas barrier film particularly under a high humidity condition are easily enhanced in a case in which the number of durability N is equal to or more than the lower limit.

Here, the steel wool test is a test which can be performed using a surface property measuring machine manufactured by SHINTO Scientific Co., Ltd. as a measuring apparatus and is specifically performed by reciprocating #0000 steel wool (preferably BON STAR steel wool #0000) to which a load of 50 gf/cm$^2$ is applied on the outermost surface (the outermost surface on the inorganic thin film layer side of the gas barrier film) under conditions of a speed of 60 rpm/min and a one-way distance of 3 cm (reciprocating distance of 6 cm) and thus generating friction between the outermost surface and the steel wool. Thereafter, in the test, the outermost surface on the inorganic thin film layer side is visually observed, the number of reciprocating friction of the steel wool until a scratch is generated is measured, and this number is taken as the number of durability N. Incidentally, the speed of 60 rpm/min indicates that the steel wool is reciprocated 60 times for one minute. In addition, to perform measurement on the outermost surface on the inorganic thin film layer side indicates to perform measurement on the surface of the inorganic thin film layer in a case in which the inorganic thin film layer included in the gas barrier film is disposed on the outermost surface of the gas barrier film, and indicates to perform measurement on the outermost surface closer to the surface of the inorganic thin film layer among the outermost surfaces of the gas barrier film in a case in which layers are further formed on the inorganic thin film layer included in the gas barrier film. In a case in which both surfaces of the gas barrier film are inorganic thin film layers and a case in which both of the outermost surfaces of the gas barrier film are present at similar distances from the surface of the inorganic thin film layer, it is only necessary that at least one of the outermost surfaces has the number of durability described above. Incidentally, the steel wool test is a testing method in which the conditions are set as described above with reference to JIS K7204.

Examples of a method for setting the number of durability of the gas barrier film in the steel wool test to the range include a method in which the reaction rate of the undercoat layer is adjusted.

In the gas barrier film of the present invention, the coefficient of dynamic friction between one outermost surface and the other outermost surface is preferably 0.5 or less, more preferably 0.4 or less, and still more preferably 0.3 or less. In a case in which the coefficient of dynamic friction is less than or equal to the upper limit, the damages to the barrier film are little in the case of performing winding of the gas barrier film at the time of the manufacture thereof or in the case of superimposing the cut films on top of one another if necessary, and it is thus easy to enhance the handleability of the gas barrier film. The lower limit of the coefficient of dynamic friction is not particularly limited and is usually 0 or more. The coefficient of dynamic friction can be measured in conformity with JIS K7125.

The gas barrier film of the present invention is preferably transparent in the case of being visually observed. Specifically, the total light transmittance (Tt) through the gas barrier film is preferably 88.0% or more, more preferably 88.5% or more, still more preferably 89.0% or more, particularly preferably 89.5% or more, and extremely preferably 90.0% or more as measured in conformity with JIS K7105: 1981. When the total light transmittance through the gas barrier film of the present invention is equal to or more than the lower limit described above, it is easy to secure sufficient visibility when the film is incorporated into a flexible electronic device such as an image display device. Incidentally, the upper limit value of the total light transmittance through the gas barrier film of the present invention is not particularly limited and may be 100% or less. The total light transmittance through the gas barrier film can be measured using a direct reading haze computer (Model HGM-2DP) manufactured by Suga Test Instruments Co., Ltd. It is preferable that the gas barrier film after being exposed to an environment at 60°C and a relative humidity of 90% for 250 hours still has a total light transmittance in the range.

The haze (haze) of the gas barrier film of the present invention is preferably 1.0% or less, more preferably 0.8% or less, and still more preferably 0.5% or less as measured using a direct reading haze computer (Model HGM-2DP) manufactured by Suga Test Instruments Co., Ltd. When the haze of the gas barrier film of the present invention is less than or equal to the upper limit described above, it is easy to secure sufficient visibility when the film is incorporated into a flexible electronic device such as an image display device. Incidentally, the lower limit value of the haze of the gas barrier film of the present invention is not particularly limited and may be 0% or more. The haze of the gas barrier film can be measured using a direct reading haze computer (Model HGM-2DP) manufactured by Suga Test Instruments Co., Ltd. It is preferable that the gas barrier film after being exposed to an environment at 60°C and a relative humidity of 90% for 250 hours still has a haze in the range.

The yellowness (b*) of the gas barrier film of the present invention is preferably 10 or less, more preferably 8 or less, and still more preferably 6 or less as measured by a spectrophotometer (CM3700d, manufactured by KONICA MINOLTA JAPAN, INC.) according to ASTM E313. When the yellowness of the gas barrier film of the present invention is less than or equal to the upper limit, the appearance looks more beautiful. Moreover, the lower limit of the yellowness is not particularly limited and is usually 0 or more. It is preferable that the gas barrier film after being exposed to an environment at 60°C and a relative humidity of 90% for 250 hours still has a yellowness in the range.

The thickness of the gas barrier film of the present invention may be appropriately adjusted depending on the application but is preferably 5 to 200 μm, more preferably 10 to 150 μm, and still more preferably 20 to 100 μm. The thickness of the gas barrier film can be measured using a thickness gauge. It is preferable that the thickness is equal to or more than the lower limit since the handleability as a film is easily improved and the pencil hardness and the like are easily increased. In addition, it is preferable that the thickness is less than or equal to the upper limit since the bending resistance of the film is easily enhanced.

(Undercoat layer)

The gas barrier film of the present invention includes at least a substrate layer, an undercoat layer, and an inorganic thin film layer in this order. The gas barrier film of the present invention is only necessary to include at least one undercoat layer present between the substrate layer and the inorganic thin film layer and may include a further undercoat layer laminated on another part as long as it includes at least the undercoat layer present in the order.

The undercoat layer may be a layer having a function as a flattening layer, a layer having a function as an anti-blocking layer, or a layer having both of these functions. The undercoat layer may be a single layer or multilayer composed of two or more layers. Moreover, inorganic particles may be contained in the undercoat layer.

The thickness of the undercoat layer in the gas barrier film of the present invention may be appropriately adjusted depending on the application but is preferably 0.1 to 5 μm, more preferably 0.5 to 3 μm, and still more preferably 1 to 3 μm. The thickness of the undercoat layer can be measured using a film thickness reflectometer. When the thickness is equal to or more than the lower limit, the pencil hardness is easily improved. In addition, when the thickness is less than or equal to the upper limit, the bending property is easily improved. In a case in which the gas barrier film of the present invention includes two or more undercoat layers, it is preferable that each undercoat layer has the thickness.

The undercoat layer can be formed, for example, by coating the substrate layer with a composition containing a photocurable compound having a polymerizable functional group and curing the composition. Examples of the photocurable compound included in the composition for forming an undercoat layer include ultraviolet or electron beam curable compounds. Examples of such compounds include compounds having one or more polymerizable functional groups in the molecule, for example, compounds having polymerizable functional groups such as a (meth)acryloyl group, a vinyl group, a styryl group, and an allyl group. The composition for forming an undercoat layer may contain one kind of photocurable compound or two or more kinds of photocurable compounds. The photocurable compound having a polymerizable functional group contained in the composition for forming an undercoat layer is polymerized by curing the photocurable compound, and an undercoat layer containing a polymer of the photocurable compound is formed.

The reaction rate of the polymerizable functional group of the photocurable compound having a polymerizable functional group in the undercoat layer is preferably 70% or more, more preferably 75% or more, and still more preferably 80% or more from the viewpoint of easily enhancing the appearance quality. The upper limit of the reaction rate is not particularly limited but is preferably 95% or less and more preferably 90% or less from the viewpoint of easily enhancing the appearance quality. In a case in which the reaction rate is equal to or more than the lower limit, the gas barrier film is likely to be colorless and transparent. In addition, in a case in which the reaction rate is less than or equal to the upper limit, the bending resistance is easily improved. The reaction rate increases as the polymerization reaction of the photocurable compound having a polymerizable functional group proceeds and thus can be increased by increasing the intensity of the ultraviolet light to radiate or increasing the irradiation time, for example, in a case in which the photocurable compound is an ultraviolet curable compound. The reaction rate can be set to be in the range by adjusting the curing conditions as described above.

The reaction rate can be attained by measuring the infrared absorption spectrums on the coating film surfaces of a coating film before curing obtained by coating a substrate with a composition for forming an undercoat layer and drying the composition if necessary and a coating film obtained by curing this coating film using total reflection type FT-IR and determining the amount of change in the intensity of the peak attributed to the polymerizable functional group. For example, in a case in which the polymerizable functional group is a (meth)acryloyl group, the C=C double bond moiety in the (meth)acryloyl group is a group involved in the polymerization, and the intensity of the peak attributed to the C=C double bond decreases as the reaction rate of polymerization increases. On the other hand, the C=O double bond moiety in the (meth)acryloyl group is not involved in the polymerization, and the intensity of the peak attributed to the C=O double bond does not change after the polymerization.

For this reason, the reaction rate can be calculated by comparing the proportion ($I_{CC1}/I_{CO1}$) of the intensity ($I_{CC1}$) of the peak attributed to the C=C double bond to the intensity ($I_{CO1}$) of the peak attributed to the C=O double bond in the (meth)acryloyl group in the infrared absorption spectrum measured for the coating film before curing with the proportion ($I_{CC2}/I_{CO2}$) of the intensity ($I_{CC2}$) of the peak attributed to the C=C double bond to the intensity ($I_{CO2}$) of the peak attributed to the C=O double bond in the (meth)acryloyl group in the infrared absorption spectrum measured for the coating film after curing. In this case, the reaction rate is calculated by Formula (3):

$$\texttt{reaction rate [\%] = [1 - (I_{CC2}/I_{CO2})/(I_{CC1}/I_{CO1})] × 100}$$

(3). Incidentally, the infrared absorption peak attributed to a C=C double bond is usually observed in the range of 1,350 to 1,450 $cm^{-1}$, for example, in the vicinity of 1,400 $cm^{-1}$ and the infrared absorption peak attributed to a C=O double bond is usually observed in the range of 1,700 to 1,800 $cm^{-1}$, for example, in the vicinity of 1,700 $cm^{-1}$.

It is preferable that $I_a$ and $I_b$ satisfy Formula (2):

$$\texttt{0.05 ≤ I_b/I_a ≤ 1.0 (2),}$$

where $I_a$ denotes the intensity of the infrared absorption peak in the range of 1,000 to 1,100 $cm^{-1}$ in the infrared absorption spectrum of the undercoat layer and $I_b$ denotes the intensity of the infrared absorption peak in the range of 1,700 to 1,800 $cm^{-1}$. Here, it is considered that the infrared absorption peak in the range of 1,000 to 1,100 $cm^{-1}$ is an infrared absorption peak attributed to a siloxane-derived Si-O-Si bond present in the compound and polymer (for example, a photocurable compound having a polymerizable functional group and/or a polymer thereof) contained in the undercoat layer and the infrared absorption peak in the range of 1,700 to 1,800 $cm^{-1}$ is an infrared absorption peak attributed to a C=O double bond present in the compound and polymer (for example, a photocurable compound having a polymerizable functional group and/or a polymer thereof) contained in the undercoat layer. Moreover, the ratio ($I_b/I_a$) between the intensities of these peaks is considered to indicate the relative proportion of C=O double bonds to siloxane-derived Si-O-Si bonds in the undercoat layer. In a case in which the ratio ($I_b/I_a$) between the peak intensities is in the predetermined range, the uniformity of the undercoat layer is easily enhanced and the adhesive property between layers particularly in a high humidity environment is easily enhanced. The ratio ($I_b/I_a$) between the peak intensities is preferably 0.05 or more, more preferably 0.10 or more, and still more preferably 0.20 or more. In a case in which the ratio between the peak intensities is equal to or more than the lower limit, the uniformity of the undercoat layer is easily enhanced. This is considered to be because aggregates are generated in the undercoat layer and the layer embrittles in some cases when the number of siloxane-derived Si-O-Si bonds present in the compound and polymer contained in the undercoat layer is too large and the generation of such aggregates is easily diminished although the present invention is not limited to the mechanism to be described later at all. The ratio ($I_b/I_a$) between the peak intensities is preferably 1.0 or less, more preferably 0.8 or less, still more preferably 0.5 or less, and particularly preferably 0.4 or less. In a case in which the ratio between the peak intensities is less than or equal to the upper limit, the adhesive property of the undercoat layer is easily enhanced. This is considered to be because the siloxane-derived Si-O-Si bonds are present in the compound and polymer contained in the undercoat layer in a certain amount or more and thus the hardness of the undercoat layer is properly decreased although the present invention is not limited to the mechanism to be described later at all. The infrared absorption spectrum of the undercoat layer can be measured using a Fourier transform type infrared spectrophotometer (FT/IR-460Plus manufactured by JASCO Corporation) equipped with an ATR attachment (PIKE MIRacle).

The photocurable compound contained in the composition for forming an undercoat layer is a compound to be a resin which is a polymer as the polymerization thereof is initiated by ultraviolet light and the like and curing thereof proceeds. The photocurable compound is preferably a compound having a (meth)acryloyl group from the viewpoint of curing efficiency. The compound having a (meth)acryloyl group may be a monofunctional monomer or oligomer or a polyfunctional monomer or oligomer. Incidentally, in the present specification, "(meth)acryloyl" represents acryloyl and/or methacryloyl and "(meth)acryl" represents acryl and/or methacryl.

Examples of the compound having a (meth)acryloyl group include (meth)acrylic compounds, and specific examples thereof include alkyl (meth)acrylate, urethane (meth)acrylate, ester (meth)acrylate, epoxy (meth)acrylate, and polymers and copolymers thereof. Specific examples thereof include methyl (meth)acrylate, butyl (meth)acrylate, methoxyethyl (meth)acrylate, butoxyethyl (meth)acrylate, phenyl (meth)acrylate, ethylene glycol di(meth)acrylate, propylene glycol di(meth)acrylate, neopentyl glycol di(meth)acrylate, dipropylene glycol di(meth)acrylate, ethylene glycol di(meth)acrylate, propylene glycol di(meth)acrylate, pentaerythritol tri(meth)acrylate, and polymers and copolymers thereof.

The photocurable compound contained in the composition for forming an undercoat layer preferably contains, for example, **tetramethoxysilane,** tetraethoxysilane, methyltrimethoxysilane, methyltriethoxysilane, ethyltrimethoxysilane, ethyltriethoxysilane, isopropyltrimethoxysilane, isobutyltrimethoxysilane, cyclohexyltrimethoxysilane, n-hexyltrimethoxysilane, n-octyltriethoxysilane, n-decyltrimethoxysilane, phenyltrimethoxysilane, dimethyldimethoxysilane, diisopropyldimethoxysilane, trimethylethoxysilane, triphenylethoxysilane and the like instead of the compound having a (meth)acryloyl group or in addition to the compound having a (meth)acryloyl group. Alkoxysilanes other than these may be used.

Examples of the photocurable compound other than the photocurable compound having a polymerizable functional group described above include monomers or oligomers which become resins such as polyester resin, isocyanate resin, ethylene vinyl alcohol resin, vinyl-modified resin, epoxy resin, phenol resin, urea melamine resin, styrene resin, and alkyl titanate by polymerization.

The composition for forming an undercoat layer may contain additives such as a solvent, a photopolymerization initiator, a thermal polymerization initiator, an antioxidant, an ultraviolet absorber, a plasticizer, a leveling agent, and a curl inhibitor if necessary in addition to the photocurable compound having a polymerizable functional group described above.

The undercoat layer can be formed, for example, by coating a substrate including at least a flexible substrate with a photocurable composition containing a photocurable compound, drying the photocurable composition if necessary, irradiating the photocurable composition with ultraviolet light or electron beams, and thus curing the photocurable compound.

Examples of the method for performing the coating include various coating methods conventionally used, for example, methods such as spray coating, spin coating, bar coating, curtain coating, dipping method, air knife method, slide coating, hopper coating, reverse roll coating, gravure coating, and extrusion coating.

In a case in which the undercoat layer has a function as a flattening layer, the undercoat layer may contain (meth)acrylate resin, polyester resin, isocyanate resin, ethylene vinyl alcohol resin, vinyl-modified resin, epoxy resin, phenol resin, urea melamine resin, styrene resin, alkyl titanate, and the like. The undercoat layer may contain one of these resins or two or more of these resins in combination.

In a case in which the undercoat layer has a function as a flattening layer, it is preferable in the flattening layer that the temperature at which the elastic modulus of the flattening layer surface decreases by 50% or more is 150°C or more in a case in which the temperature dependent change of the elastic modulus of the flattening layer surface is evaluated using a rigid pendulum type physical property testing machine (for example, RPT-3000W manufactured by A & D Company, Limited).

In a case in which the undercoat layer has a function as a flattening layer, the surface roughness measured by observing the flattening layer under a white interference microscope is preferably 3 nm or less, more preferably 2 nm or less, and still more preferably 1 nm or less. In a case in which the surface roughness of the flattening layer is less than or equal to the upper limit, there is an effect that defects of the barrier layer decrease and the barrier property is further enhanced. The surface roughness is measured by observing the flattening layer under a white interference microscope and forming interference fringes according to the irregularities of the sample surface.

In a case in which the undercoat layer has a function as an anti-blocking layer, the undercoat layer may contain inorganic particles in addition to the resin described above.

Examples of the inorganic particles include silica, alumina, talc, clay, calcium carbonate, magnesium carbonate, barium sulfate, aluminum hydroxide, titanium dioxide, and zirconium oxide.

(Inorganic thin film layer)

The gas barrier film of the present invention includes at least a substrate layer, an undercoat layer, and an inorganic thin film layer in this order. The gas barrier film of the present invention is only necessary to include at least one inorganic thin film layer laminated on the surface on the opposite side to the surface in contact with the substrate layer of the undercoat layer laminated at least on one surface of the substrate layer and may include a further inorganic thin film layer laminated on another part as long as it includes at least one inorganic thin film layer present in the order. The inorganic thin film layer is not particularly limited as long as it is a layer of an inorganic material exhibiting gas barrier property, and a layer of a known inorganic material exhibiting gas barrier property can be appropriately utilized. Examples of the inorganic material include metal oxides, metal nitrides, metal oxynitrides, metal oxycarbides, and mixtures containing at least two of these. The inorganic thin film layer may be a single-layer film or a multilayer film in which two or more layers including at least the thin film layer are laminated.

The thickness of the inorganic thin film layer in the gas barrier film of the present invention may be appropriately adjusted depending on the application but is preferably 0.1 to 2 $\mu$m, more preferably 0.2 to 1.5 $\mu$m, and still more preferably 0.3 to 1 $\mu$m. The thickness of the inorganic thin film layer can be measured using a step gauge. When the thickness is equal to or more than the lower limit, the barrier property is easily improved. In addition, when the thickness is less than or equal to the upper limit, the bending property is easily improved. In a case in which the gas barrier film of the present invention includes two or more inorganic thin film layers, it is preferable that each inorganic thin film layer has the thickness.

It is preferable that the inorganic thin film layer contains at least a silicon atom (Si), an oxygen atom (O), and a carbon atom (C) from the viewpoint of easily exerting higher gas barrier property (particularly water vapor transmission preventing property) and from the viewpoint of bending resistance, ease of manufacture, and low manufacturing cost.

In this case, the main component of the inorganic thin film layer can be a compound represented by a general formula of $SiO_\alpha C_\beta$ [where $\alpha$ and $\beta$ each independently denote a positive number less than 2]. Here, "to be a main component" means that the content of the component is 50% by mass or more, preferably 70% by mass or more, and more preferably 90% by mass or more with respect to the mass of all components of the material. The inorganic thin film layer may contain one compound represented by the general formula $SiO_\alpha C_\beta$ or two or more compounds represented by the general formula $SiO_\alpha C_\beta$. $\alpha$ and/or $\beta$ in the general formula may be constant values or vary in the film thickness direction of the inorganic thin film layer.

Furthermore, the inorganic thin film layer may contain elements other than the silicon atom, oxygen atom, and carbon atom, for example, one or more atoms among a hydrogen atom, a nitrogen atom, a boron atom, an aluminum atom, a phosphorus atom, a sulfur atom, a fluorine atom, and a chlorine atom.

In a case in which the average ratio of the number of carbon atoms (C) to the number of silicon atoms (Si) in the inorganic thin film layer is represented by C/Si, it is preferable in the inorganic thin film layer that the range of C/Si satisfies Formula (4) from the viewpoint of enhancing the compactness and decreasing defects such as fine voids and cracks.

$$0.02 < C/Si < 0.50 \quad (4)$$

C/Si is more preferably in the range of 0.03 < C/Si < 0.45, still more preferably in the range of 0.04 < C/Si < 0.40, and particularly preferably in the range of 0.05 < C/Si < 0.35 from the same viewpoint.

In addition, in a case in which the average ratio of the number of oxygen atoms (O) to number of silicon atoms (Si) in the inorganic thin film layer is represented by O/Si, O/Si is preferably in the range of 1.50 < O/Si < 1.98, more preferably in the range of 1.55 < O/Si < 1.97, still more preferably in the range of 1.60 < O/Si < 1.96, and particularly preferably in the range of 1.65 < O/Si < 1.95 in the inorganic thin film layer from the viewpoint of enhancing the compactness and decreasing defects such as fine voids and cracks.

Incidentally, the average ratios between the numbers of atoms C/Si and O/Si can be measured by determining the average atomic concentration of each atom in the thickness direction from the distribution curves of silicon atoms, oxygen atoms, and carbon atoms attained by performing the XPS depth profile measurement under the following conditions and then calculating the average ratios between the numbers of atoms C/Si and O/Si.

<XPS depth profile measurement>

Etching ion species: Argon (Ar$^+$)
Etching rate (SiO$_2$ thermal oxide film equivalent): 0.027 nm/sec
Sputtering time: 0.5 min
X-ray photoelectron spectrometer: Quantera SXM manufactured by ULVAC-PHI, INCORPORATED.
Irradiation X-ray: Single crystal spectroscopy AlK$\alpha$ (1,486.6 eV)
X-ray spot and size: 100 $\mu$m
Detector: Pass Energy 69eV, Step size 0.125eV
Charge correction: Neutralizing electron gun (1 eV), Low-speed Ar ion gun (10 V)
In a case in which the surface of the inorganic thin film layer is subjected to infrared spectroscopic (ATR method) measurement, it is preferable that the intensity ratio ($I_2/I_1$) of the peak intensity ($I_1$) present at 950 to 1,050 cm$^{-1}$ to the peak intensity ($I_2$) present at 1,240 to 1,290 cm$^{-1}$ satisfies Formula (5).

$$0.01 \leq I_2/I_1 < 0.05 \quad (5)$$

The peak intensity ratio $I_2/I_1$ calculated from the results of infrared spectroscopic (ATR method) measurement is considered to indicate the relative proportion of Si-CH$_3$ to Si-O-Si in the inorganic thin film layer. The inorganic thin film layer satisfying the relationship represented by Formula (5) exhibits high compactness, defects such as fine voids and cracks are easily decreased, and it is thus considered that the gas barrier property and impact resistance are easily improved. The peak intensity ratio $I_2/I_1$ is more preferably in the range of $0.02 \leq I_2/I_1 < 0.04$ from the viewpoint of being easy to maintain the compactness of the inorganic thin film layer high.

In a case in which the inorganic thin film layer satisfies the range of the peak intensity ratio $I_2/I_1$, the gas barrier film of the present invention is properly slippery and blocking is easily diminished. The fact that the peak intensity ratio $I_2/I_1$ is too large means that the number of Si-C is too large. In this case, the bending property tends to be poor and slippage tends to hardly occur. In addition, when the peak intensity ratio $I_2/I_1$ is too small, the bending property tends to decrease due to a too small number of Si-C.

The infrared spectroscopic measurement of the surface of the inorganic thin film layer can be performed using a Fourier transform type infrared spectrophotometer (FT/IR-460Plus manufactured by JASCO Corporation) equipped with an ATR attachment (PIKE MIRacle) using germanium crystal as prism.

In a case in which the surface of the inorganic thin film layer is subjected to infrared spectroscopic (ATR method) measurement, it is preferable that the intensity ratio ($I_3/I_1$) of the peak intensity ($I_1$) present at 950 to 1,050 cm$^{-1}$ to the peak intensity ($I_3$) present at 770 to 830 cm$^{-1}$ satisfies Formula (6).

$$0.25 \leq I_3/I_1 \leq 0.50 \quad (6)$$

The peak intensity ratio $I_3/I_1$ calculated from the results of spectroscopic (ATR method) measurement is considered to indicate the relative proportion of Si-C, Si-O and the like to Si-O-Si in the inorganic thin film layer. With regard to the inorganic thin film layer which satisfies the relationship represented by Formula (6), it is considered that the bending resistance is easily enhanced since carbon is introduced into the layer and the impact resistance is also easily enhanced while high compactness is maintained. The peak intensity ratio $I_3/I_1$ is preferably in the range of $0.25 \leq I_3/I_1 \leq 0.50$ and more preferably in the range of $0.30 \leq I_3/I_1 \leq 0.45$ from the viewpoint of maintaining the balance between the compactness and bending resistance of the inorganic thin film layer.

In a case in which the thin film layer surface is subjected to infrared spectroscopic (ATR method) measurement, it is preferable in the thin film layer that the intensity ratio of the peak intensity ($I_3$) present at 770 to 830 cm$^{-1}$ to the peak intensity ($I_4$) present at 870 to 910 cm$^{-1}$ satisfies Formula (7) .

$$0.70 \leq I_4/I_3 < 1.00 \quad (7)$$

The peak intensity ratio $I_4/I_3$ calculated from the results of infrared spectroscopic (ATR method) measurement is considered to represent the ratio between peaks related to Si-C in the inorganic thin film layer. With regard to the inorganic thin film layer which satisfies the relationship represented by Formula (7), it is considered that the bending resistance is easily enhanced since carbon is introduced into the layer and the impact resistance is also easily enhanced while high compactness is maintained. With regard to the range of the peak intensity ratio $I_4/I_3$, a range of $0.70 \leq I_4/I_3 < 1.00$ is preferable and a range of $0.80 \leq I_4/I_3 < 0.95$ is more preferable from the viewpoint of maintaining the balance between the compactness and bending resistance of the inorganic thin film layer.

The thickness of the inorganic thin film layer is preferably 5 to 3,000 nm from the viewpoint that the inorganic thin film layer is hardly cracked when being bent. Furthermore, as to be described later, in a case in which a thin film layer is formed by a plasma CVD method using glow discharge plasma, the thin film layer is formed while electricity is discharged through the substrate and thus the thickness is more preferably 10 to 2,000 nm and still preferably 100 to 1,000 nm.

The inorganic thin film layer may preferably have a high average density of 1.8 g/cm$^3$ or more. Here, the "average density" of the inorganic thin film layer is determined by calculating the weight of the thin film layer in the measurement range from the number of silicon atoms, the number of carbon atoms, and the number of oxygen atoms determined by Rutherford Backscattering Spectrometry (RBS) and the number of hydrogen atoms determined by Hydrogen Forward scattering Spectrometry (HFS) and dividing the weight by the volume (the product of the area irradiated with the ion beam and the film thickness) of the thin film layer in the measurement range. It is preferable that the average density of the inorganic thin film layer is equal to or more than the lower limit since the inorganic thin film layer has a structure which exhibits high compactness and in which defects such as fine voids and cracks are easily decreased. In a preferred aspect of the present invention in which the inorganic thin film layer contains silicon atoms, oxygen atoms, carbon atoms, and hydrogen atoms, the average density of the inorganic thin film layer is preferably less than 2.22 g/cm$^3$.

In a preferred aspect of the present invention in which the inorganic thin film layer contains at least a silicon atom (Si), an oxygen atom (O), and a carbon atom (C), a curve indicating the relationship between the distance from the inorganic thin film layer surface in the film thickness direction of the inorganic thin film layer and the atomic ratio of silicon atoms at each distance is called a silicon distribution curve. Here, the inorganic thin film layer surface refers to a surface to be a surface of the gas barrier film of the present invention. Similarly, a curve indicating the relationship between the distance from the inorganic thin film layer surface in the film thickness direction and the atomic ratio of oxygen atoms at each distance is called an oxygen distribution curve. In addition, a curve indicating the relationship between the distance from the inorganic thin film layer surface in the film thickness direction and the atomic ratio of carbon atoms at each distance is called a carbon distribution curve. The atomic ratio of silicon atoms, the atomic ratio of oxygen atoms, and the atomic ratio of carbon atoms mean the ratios of the respective numbers of atoms to the total number of silicon atoms, oxygen atoms, and carbon atoms contained in the inorganic thin film layer.

It is preferable that the ratio of the number of carbon atoms to the total number of silicon atoms, oxygen atoms, and carbon atoms contained in the inorganic thin film layer continuously changes in 90% or more of the region in the film thickness direction of the inorganic thin film layer from the viewpoint of easily suppressing a decrease in gas barrier property due to bending. Here, the fact that the ratio of the number of carbon atoms continuously changes in the film thickness direction of the inorganic thin film layer indicates, for example, that the carbon distribution curve does not include a part at which the atomic ratio of carbon discontinuously changes.

Specifically, it is preferable that the following Formula (9) is satisfied when the distance from the thin film layer surface in the film thickness direction is denoted as $\times$ [nm] and the atomic ratio of carbon is denoted as C.

It is preferable that the carbon distribution curve of the inorganic thin film layer has eight or more extreme values from the viewpoint of bending property and barrier property of the film.

It is preferable that the silicon distribution curve, oxygen distribution curve, and carbon distribution curve of the inorganic thin film layer satisfy the following conditions (i) and (ii) from the viewpoint of bending property and barrier property of the film.

(i) The ratio of the number of silicon atoms, the ratio of the number of oxygen atoms, and the ratio of the number of carbon atoms satisfy the condition represented by Formula (8) in 90% or more of the region in the film thickness direction of the thin film layer:

(ratio of number of oxygen atoms) > (ratio of number of silicon atoms) > (ratio of number of carbon atoms) (8), and

(ii) The carbon distribution curve preferably has at least one extreme value and more preferably has eight or more extreme values.

It is preferable that the carbon distribution curve of the inorganic thin film layer is substantially continuous. The fact that the carbon distribution curve is substantially continuous means that the carbon distribution curve does not include a part at which the atomic ratio of carbon discontinuously changes. Specifically, it is preferable that Formula (9) is satisfied when the distance from the thin film layer surface in the film thickness direction is denoted as × [nm] and the atomic ratio of carbon is denoted as C.

$$|dC/dx| \leq 0.01 \quad (9)$$

Moreover, the carbon distribution curve of the inorganic thin film layer preferably has at least one extreme value and more preferably has eight or more extreme values. The extreme value used herein is the maximum value or minimum value of the atomic ratio of each element with respect to the distance from the inorganic thin film layer surface in the film thickness direction. The extreme value is the value of the atomic ratio at the point at which the atomic ratio of element turns from an increase to a decrease or the point at which the atomic ratio of element turns from a decrease to an increase when the distance from the inorganic thin film layer surface in the film thickness direction is changed. The extreme value can be determined based on the measured atomic ratios, for example, at a plurality of measurement positions in the film thickness direction. The measurement position of the atomic ratio is set to a position at which the interval in the film thickness direction is, for example, 20 nm or less. The position having an extreme value in the film thickness direction can be attained by determining the position at which the measurement result turns from an increase to a decrease or the position at which the measurement result turns from a decrease to an increase by, for example, comparing the measurement results at three or more different measurement positions for the discrete data group including the measurement results at the respective measurement positions. The position having an extreme value can be attained by, for example, differentiating the approximate curve determined from the discrete data group. In a case in which the section at which the atomic ratio monotonically increases or monotonically decreases from the position having an extreme value is, for example, 20 nm or more, the absolute value of the difference between the atomic ratio at a position shifted by 20 nm in the film thickness direction from the position having an extreme value and the extreme value is, for example, 0.03 or more.

In the inorganic thin film layer formed so as to satisfy the condition that the carbon distribution curve preferably has at least one extreme value and more preferably eight or more extreme values as described above, the amount of increase in the gas permeability after bending with respect to the gas permeability before bending is smaller than in a case in which the condition is not satisfied. In other words, an effect of suppressing a decrease in gas barrier property due to bending is attained as the condition is satisfied. When the thin film layer is formed so that the number of extreme values in the carbon distribution curve is two or more, the amount of increase is smaller than in a case in which the number of extreme values in the carbon distribution curve is one. In addition, when the thin film layer is formed so that the number of extreme values in the carbon distribution curve is three or more, the amount of increase is smaller than in a case in which the number of extreme values in the carbon distribution curve is two. In a case in which the carbon distribution curve has two or more extreme values, the absolute value of the difference between the distance from the thin film layer surface in the film thickness direction at a position having the first extreme value and the distance from the thin film layer surface in the film thickness direction at a position having the second extreme value adjacent to the first extreme value is preferably in a range of 1 nm or more and 200 nm or less and more preferably in a range of 1 nm or more and 100 nm or less.

Moreover, it is preferable that the absolute value of the difference between the maximum value and minimum value of the atomic ratio of carbon in the carbon distribution curve of the inorganic thin film layer is greater than 0.01. In the inorganic thin film layer formed so as to satisfy the condition, the amount of increase in the gas permeability after bending with respect to the gas permeability before bending is smaller than that in a case in which the condition is not satisfied.

In other words, an effect of suppressing a decrease in gas barrier property due to bending is attained as the condition is satisfied. The effect is enhanced when the absolute value of the difference between the maximum value and minimum value of the atomic ratio of carbon is 0.02 or more, and the effect is further enhanced when the absolute value is 0.03 or more.

As the absolute value of the difference between the maximum value and minimum value of the atomic ratio of silicon in the silicon distribution curve decreases, the gas barrier property of the inorganic thin film layer tends to be improved. From such a viewpoint, the absolute value is preferably less than 0.05 (less than 5 at%), more preferably less than 0.04 (less than 4 at%), and particularly preferably less than 0.03 (less than 3 at%).

Moreover, in the oxygen-carbon distribution curve, when the sum of the atomic ratio of oxygen atoms and the atomic ratio of carbon atoms at each distance is defined as "total atomic ratio, the gas barrier property of the thin film layer tends to be improved as the absolute value of the difference between the maximum value and minimum value of the total atomic ratio decreases. From such a viewpoint, the total atomic ratio is preferably less than 0.05, more preferably less than 0.04, and particularly preferably less than 0.03.

When the inorganic thin film layer has a substantially uniform composition in the inorganic thin film layer surface direction, the gas barrier property of the inorganic thin film layer can be uniformized and improved. To have substantially uniform composition means that the respective numbers of extreme values present in the film thickness direction are the same as each other at arbitrary two points on the inorganic thin film layer surface and the absolute values of the differences between the maximum value and minimum value of the atomic ratio of carbon in the respective carbon distribution curves are the same as each other or different from each other within 0.05 in the oxygen distribution curve, carbon distribution curve, and oxygen-carbon distribution curve.

The inorganic thin film layer formed so as to satisfy the condition can exert gas barrier property required for a flexible electronic device using an organic EL element, for example.

In a preferred aspect of the present invention in which the inorganic thin film layer contains at least a silicon atom, an oxygen atom, and a carbon atom, the layer of an inorganic material containing such atoms is preferably formed by a chemical vapor deposition method (CVD method) from the viewpoint of enhancing the compactness and decreasing defects such as fine voids and cracks. Among others, the layer of an inorganic material is more preferably formed by plasma enhanced chemical vapor deposition method (PECVD method) using glow discharge plasma and the like.

An example of a source gas to be used in the chemical vapor deposition method is an organosilicon compound containing a silicon atom and a carbon atom. Examples of such an organosilicon compound include hexamethyldisiloxane, 1,1,3,3-tetramethyldisiloxane, vinyltrimethylsilane, methyltrimethylsilane, hexamethyldisilane, methylsilane, dimethylsilane, trimethylsilane, diethylsilane, propylsilane, phenylsilane, vinyltriethoxysilane, vinyltrimethoxysilane, tetramethoxysilane, tetraethoxysilane, phenyltrimethoxysilane, methyltriethoxysilane, and octamethylcyclotetrasiloxane. Among these organosilicon compounds, hexamethyldisiloxane and 1,1,3,3-tetramethyldisiloxane are preferable from the viewpoint of the handleability of compound and the properties such as gas barrier property of the inorganic thin film layer to be obtained. As the source gas, these organosilicon compounds may be used singly or in combination of two or more thereof.

In addition, a reactant gas capable of forming an inorganic compound such as an oxide or a nitride by reacting with the source gas can be appropriately selected and mixed with the source gas. As the reactant gas for forming an oxide, for example, oxygen and ozone can be used. As the reactant gas for forming a nitride, for example, nitrogen and ammonia can be used. These reactant gases can be used singly or in combination of two or more thereof, and a reactant gas for forming an oxide and a reactant gas for forming a nitride can be used in combination, for example, in the case of forming an oxynitride. The flow ratio between the source gas and the reactant gas can be appropriately adjusted according to the atomic ratio of the inorganic material to be deposited.

In order to supply the source gas into the vacuum chamber, a carrier gas may be used if necessary. Furthermore, a discharge gas may be used if necessary in order to generate plasma discharge. As such carrier gas and discharge gas, known gases can be appropriately used. For example, rare gases such as helium, argon, neon, and xenon; and hydrogen can be used.

In addition, the pressure (degree of vacuum) in the vacuum chamber can be appropriately adjusted depending on the kind of source gas and the like but is preferably set to be in a range of 0.5 to 50 Pa.

(Substrate layer)

The gas barrier film of the present invention has a substrate layer including at least a flexible substrate. The flexible substrate is a substrate which exhibits flexibility and can hold the inorganic thin film layer. As the flexible substrate, it is possible to use a resin film containing at least one resin as a resin component. The flexible substrate is preferably a transparent resin substrate.

Examples of the resin which can be used in the flexible substrate include polyester resins such as polyethylene terephthalate (PET) and polyethylene naphthalate (PEN); polyolefin resins such as polyethylene (PE), polypropylene (PP), and cyclic polyolefin; polyamide resins; polycarbonate resins; polystyrene resins; polyvinyl alcohol resins; saponified products of ethylene-vinyl acetate copolymer; polyacrylonitrile resins; acetal resins; polyimide resins; and polyether sulfide (PES). As the flexible substrate, the resins may be used singly or in combination of two or more thereof. Among these, it is preferable to use a resin selected from the group consisting of polyester resins and polyolefin resins and it is more preferable to use a resin selected from the group consisting of PET, PEN, and cyclic polyolefin from the viewpoint of easily enhancing the properties such as transparency, heat resistance, and linear expansion property.

The flexible substrate may be an unstretched resin substrate or a stretched resin substrate obtained by stretching an unstretched resin substrate in the flow direction (MD direction) of the resin substrate and/or in a direction (TD direction) perpendicular to the flow direction of the resin substrate by known methods such as uniaxial stretching, tenter-type sequential biaxial stretching, tenter-type simultaneous biaxial stretching, and tubular simultaneous biaxial stretching. The flexible substrate may be a laminate in which two or more layers of the resins described above are laminated.

The thickness of the flexible substrate may be appropriately set in consideration of stability and the like when the gas barrier film is manufactured but is preferably 5 to 500 $\mu$m from the viewpoint of facilitating the transportation of the flexible substrate in a vacuum. Furthermore, in a case in which the inorganic thin film layer is formed by the plasma CVD method, the thickness of the flexible substrate is more preferably 10 to 200 $\mu$m and still more preferably 15 to 100 $\mu$m. Here, the thickness of the flexible substrate is measured using a dial gauge or an interference type thickness gauge.

The flexible substrate may be a retardation film in which two in-plane orthogonal components have different refractive indices from each other, such as a $\lambda/4$ retardation film and a $\lambda/2$ retardation film. Examples of the material for the retardation film include a cellulose-based resin, a polycarbonate-based resin, a polyarylate-based resin, a polyester-based resin, an acrylic resin, a polysulfone-based resin, a polyethersulfone-based resin, a cyclic olefin-based resin, and an oriented and solidified layer of a liquid crystal compound. Among these, a polycarbonate-based resin film is preferably used since a uniform film is available at low cost. As the film forming method, it is possible to use a solvent casting method and a precision extrusion method which can decrease the residual stress of the film, but a solvent casting method is preferably used from the viewpoint of uniformity. The stretching method is not particularly limited, and it is possible to apply longitudinal uniaxial stretching in between rolls, horizontal uniaxial stretching in a tenter, and the like that can provide uniform optical properties.

In a case in which the flexible substrate is a $\lambda/4$ retardation film, the in-plane retardation Re (550) at a wavelength of 550 nm can be 100 to 180 nm and is preferably 110 to 170 nm and still more preferably 120 to 160 nm.

In a case in which the flexible substrate is a $\lambda/2$ retardation film, the in-plane retardation Re (550) at a wavelength of 550 nm can be 220 to 320 nm and is preferably 240 to 300 nm and still more preferably 250 to 280 nm.

In a case in which the flexible substrate is a retardation film, the flexible substrate may exhibit reverse wavelength dispersion property in which the retardation value increases according to the wavelength of the measured light, the flexible substrate may exhibit positive wavelength dispersion property in which the retardation value decreases according to the wavelength of the measured light, or the flexible substrate may exhibit flat wavelength dispersion property in which the retardation value hardly changes depending on the wavelength of the measured light.

In a case in which the flexible substrate is a retardation film exhibiting reverse wavelength dispersion property, the flexible substrate can satisfy Re (450)/Re (550) < 1 and Re (650)/Re (550) > 1, where Re ($\lambda$) denotes the retardation of the flexible substrate at a wavelength $\lambda$.

The flexible substrate is preferably colorless and transparent from the viewpoint of being able to transmit or absorb light. More specifically, the total light transmittance is preferably 80% or more and more preferably 85% or more.

Moreover, the haze (haze) is preferably 5% or less, more preferably 3% or less, and still more preferably 1% or less.

The flexible substrate preferably exhibits insulation property and an electric resistivity of $10^6$ $\Omega$cm or more from the viewpoint of being able to be used as a substrate for organic devices and energy devices.

The surface of the flexible substrate may be subjected to a surface activation treatment for cleaning the surface from the viewpoint of adhesive property to the inorganic thin film layer and the like. Examples of such a surface activation treatment include a corona treatment, a plasma treatment, and a flame treatment.

In the gas barrier film of the present invention, the substrate layer may include a primary layer, an easy-adhesion layer, a curl adjusting layer, a stress relaxation layer, a heat-resistant layer, and the like in addition to the flexible substrate. For this reason, in the present invention, the flexible substrate and the part at which a primary layer and the like as described above are laminated are combined to form the substrate layer. In other words, in the gas barrier film of the present invention, the flexible substrate included in the substrate layer and the undercoat layer are not necessarily required to be adjacent to each other, a primary layer and the like as described above may be laminated between the flexible substrate and the undercoat layer.

(Layer configuration)

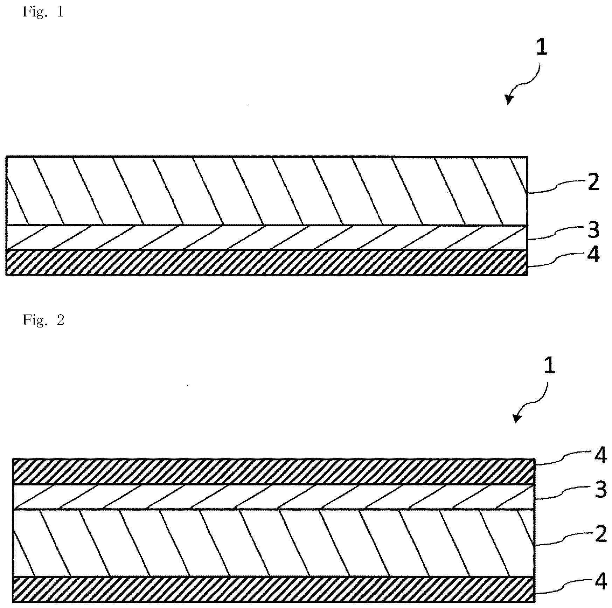

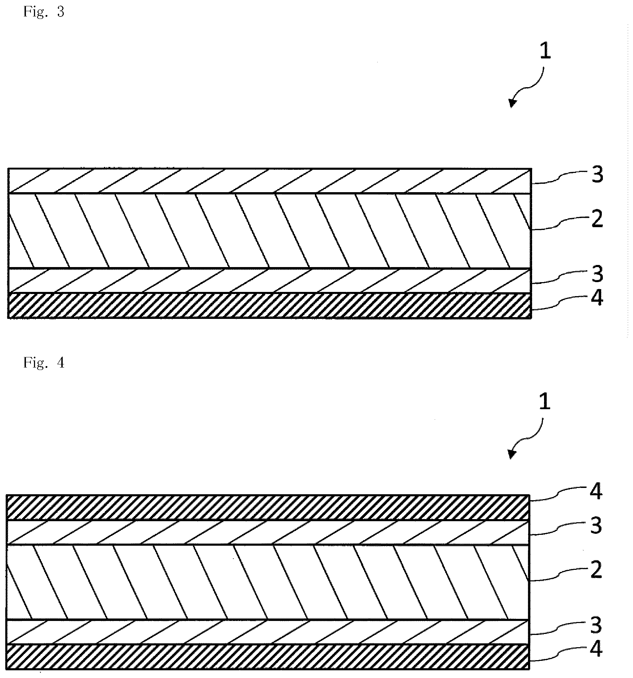

The layer configuration of the gas barrier film of the present invention is not particularly limited as long as the gas barrier film includes at least a substrate layer, an undercoat layer, and an inorganic thin film layer in this order. Specifically, the layer configuration may be a three-layer configuration of substrate layer/undercoat layer/inorganic thin film layer (the configuration illustrated in Fig. 1), a four-layer configuration of inorganic thin film layer/substrate layer/undercoat layer/inorganic thin film layer (the configuration illustrated in Fig. 2), undercoat layer/substrate layer/undercoat layer/inorganic thin film layer (the configuration illustrated in Fig. 3), or substrate layer/undercoat layer/inorganic thin film layer/undercoat layer, or a configuration including five or more layers of inorganic thin film layer/undercoat layer/substrate layer/undercoat layer/inorganic thin film layer (the configuration illustrated in Fig. 4), undercoat layer/inorganic thin film layer/substrate layer/undercoat layer/inorganic thin film layer, or undercoat layer/inorganic thin film layer/substrate layer/undercoat layer/inorganic thin film layer/undercoat layer. Incidentally, each layer in the layer configuration of the gas barrier film of the present invention may be a single layer or a multilayer. In addition, in a case in which two or more substrate layers are included in the layer configuration of the gas barrier film of the present invention, the two or more substrate layers may be the same layer or different layers. The same applies to a case in which two or more undercoat layers or two or more inorganic thin film layers are included. Further layers may be included in addition to the layers described above. Examples of the further layers include an easy-lubricating layer, a hard coat layer, a transparent conductive film layer, and a color filter layer. Incidentally, as described above, the undercoat layer may be a layer having a function as a flattening layer, a layer having a function as an anti-blocking layer, or a layer having both of these functions.

Hence, the undercoat layer can be reworded as, for example, an anti-blocking layer or a flattening layer. As presented in the examples of layer configuration, the gas barrier film of the present invention may have a layer configuration of, for example, undercoat layer (first undercoat layer)/substrate layer/undercoat layer (second undercoat layer)/inorganic thin film layer. In this case, the first undercoat layer is a layer present on the outermost surface of the gas barrier film. As is clear from the examples of layer configuration, in the present specification, the undercoat layer does not mean to be a layer present under any layer but is a layer which can be reworded as, for example, an anti-blocking layer or a flattening layer.

(First embodiment)

In a preferred first embodiment, the gas barrier film of the present invention has at least a layer configuration (the configuration illustrated in Fig. 1) of substrate layer/undercoat layer/inorganic thin film layer. In the present embodiment, the undercoat layer may be a layer having a function as a flattening layer or a layer having a function as an anti-blocking layer but is preferably a layer having a function as a flattening layer.

(Second embodiment)

In a preferred second embodiment, the gas barrier film of the present invention has at least a layer configuration (the configuration illustrated in Fig. 2) of inorganic thin film layer A/substrate layer/undercoat layer/inorganic thin film layer B. In the present embodiment, the undercoat layer may be a layer having a function as a flattening layer or a layer having a function as an anti-blocking layer but is preferably a layer having a function as a flattening layer. In the present embodiment, the gas barrier film includes at least two inorganic thin film layers, and thus these are referred to as an inorganic thin film layer A and an inorganic thin film layer B. As described above, the inorganic thin film layer A and the inorganic thin film layer B may be the same layer or layers different from each other in composition, number of layers, and the like.

(Third embodiment)

In a preferred third embodiment, the gas barrier film of the present invention has at least a layer configuration (the configuration illustrated in Fig. 3) of undercoat layer A/substrate layer/undercoat layer B/inorganic thin film layer. In the present embodiment, the gas barrier film includes at least two undercoat layers, and thus these are referred to as an undercoat layer A and an undercoat layer B. In the present embodiment, as described above, the undercoat layer A and the undercoat layer B may be the same layer or layers different from each other in composition, function, number of layers, and the like. In the present embodiment, the undercoat layer A and the undercoat layer B may each be a layer having a function as a flattening layer or a layer having a function as an anti-blocking layer, but it is preferable that the undercoat layer A is a layer having a function as an anti-blocking layer and the undercoat layer B is a layer having a function as a flattening layer. In the case of having such a layer configuration, the damages to the barrier film decrease in the case of performing winding of the gas barrier film at the time of the manufacture thereof or in the case of superimposing the cut films on top of one another if necessary.

(Fourth embodiment)

In a preferred fourth embodiment, the gas barrier film of the present invention has at least a layer configuration (the configuration illustrated in Fig. 4) of inorganic thin film layer A/undercoat layer A/substrate layer/undercoat layer B/inorganic thin film layer B. In the present embodiment, as described above, the undercoat layer A and the undercoat layer B may be the same layer or layers different from each other in composition, function, number of layers, and the like. In addition, as described above, the inorganic thin film layer A and the inorganic thin film layer B may be the same layer or layers different from each other in composition, number of layers, and the like. In the present embodiment, the undercoat layer A and the undercoat layer B may each be a layer having a function as a flattening layer or a layer having a function as an anti-blocking layer, but it is preferable that the undercoat layer A is a layer having a function as an anti-blocking layer and the undercoat layer B is a layer having a function as a flattening layer. In the case of having such a layer configuration, both the barrier property and transportability of the film can be achieved.

The gas barrier film of the present invention can be manufactured by a method in which a substrate layer, an undercoat layer, and an inorganic thin film layer are separately manufactured and bonded to each other, a method in which an undercoat layer is formed on a substrate layer and then an inorganic thin film layer is further formed thereon, and the like. From the viewpoint of easily enhancing the compactness of the inorganic thin film layer and easily decreasing defects such as fine voids and cracks, it is preferable that the film is manufactured by forming the thin film layer on a flexible substrate or an undercoat layer laminated on the surface of the flexible substrate using a glow discharge plasma by a known vacuum deposition method such as a CVD method as described above. A further undercoat layer may be formed on the laminated film thus obtained by a known method. The inorganic thin film layer is preferably formed by a continuous deposition process. For example, it is more preferable to continuously form a thin film layer on a long substrate while continuously transporting the long substrate. Specifically, an inorganic thin film layer may be formed while transporting the flexible substrate on which an undercoat layer is formed from the delivery roll to the wind-up roll. Thereafter, the delivery roll and the wind-up roll may be reversed to transport the substrate in the opposite direction, and an inorganic thin film layer may be further formed thereon.

The gas barrier film of the present invention may include a protective thin film layer formed by applying a coating liquid containing a silicon compound on the inorganic thin film layer and subjecting the coating film obtained to a modification treatment.

Upon the formation of the protective thin film layer, the silicon compound is preferably a polysiloxane compound, a polysilazane compound, a polysilane compound, or a mixture thereof. In particular, inorganic silicon compounds such as hydrogenated silsesquioxane and perhydropolysilazane are preferable. Examples of perhydropolysilazane include AZ inorganic silazane coating materials (NAX series, NL series, and NN series) manufactured by Performance Materials business sector of Merck KGaA.

Upon the formation of the protective thin film layer, examples of the method for applying a coating liquid containing a silicon compound include various coating methods conventionally used, for example, methods such as spray coating, spin coating, bar coating, curtain coating, dipping method, air knife method, slide coating, hopper coating, reverse roll coating, gravure coating, and extrusion coating.

The thickness of the protective thin film layer is appropriately set depending on the purpose, and the protective thin film layer is formed in a range of, for example, 10 nm to 10 $\mu$m and more preferably 100 nm to 1 $\mu$m. Moreover, the protective thin film layer is preferably flat, and the average surface roughness attained by observation under a white interference microscope is preferably 50 nm or less and more preferably 10 nm or less.

Upon the formation of the protective thin film layer, the film thickness can be adjusted to a desired film thickness by one time of coating or the film thickness can be adjusted to a desired film thickness by plural times of coating. In the case of performing plural times of coating, it is preferable to perform the modification treatment for every time of coating.

Upon the formation of the protective thin film layer, examples of the modification treatment method of the coating film include heat treatment, wet heat treatment, plasma treatment, ultraviolet irradiation treatment, excimer irradiation treatment (vacuum ultraviolet irradiation treatment), electron beam irradiation treatment, and ion implantation treatment.

Excimer irradiation treatment, ion implantation treatment and the like are preferable from the viewpoint of efficiently modifying the surface and/or interior of the coating film to silicon oxide or silicon oxynitride at a low temperature.

The gas barrier film of the present invention exhibits excellent gas barrier property. The gas barrier film of the present invention can be used in the packaging applications of foods, industrial articles, pharmaceuticals and the like, in which gas barrier property is required. The present invention also provides a flexible electronic device including the gas barrier film of the present invention. The gas barrier film of the present invention can also be used as a flexible substrate of flexible electronic devices (for example, flexible displays) such as liquid crystal display devices, solar cells, organic EL displays, organic EL micro displays, organic EL lighting, and electronic paper, which are required to exhibit higher gas barrier property. In a case in which the gas barrier film of the present invention is used as a flexible substrate of an electronic device, an element may be formed directly on the gas barrier film of the present invention, or an element may be formed on another substrate and then the gas barrier film of the present invention may be superimposed on the element with an adhesive layer or a pressure sensitive adhesive layer interposed therebetween.

EXAMPLES

Hereinafter, the present invention will be described specifically with reference to Examples and Comparative Examples, but the present invention is not limited to these Examples.

[Film thickness]

An inorganic thin film layer and an undercoat layer were formed on a flexible substrate, and the step difference between a non-deposited portion and a deposited portion was measured using SURFCODER ET200 manufactured by Kosaka Laboratory, Ltd., and the film thickness (T) of each layer was determined.

[Water vapor transmission rate of gas barrier film]

**[0116]** The water vapor transmission rate was measured by a Ca corrosion testing method in conformity with ISO/WD 15106-7 (Annex C) under the conditions of a temperature of 23°C and a humidity of 50% RH.

[Number of durability N of outermost surface on inorganic thin film layer side of gas barrier film]

**[0117]** A steel wool test was performed by rubbing the outermost surface on the side of the inorganic thin film layer laminated on the undercoat layer of the gas barrier film using #0000 steel wool under conditions a speed of 60 rpm/min and a one-way distance of 3 cm (reciprocating distance of 6 cm) while applying a load of 50 gf/$cm^2$ to the outermost surface, the outermost surface on the side of the inorganic thin film layer laminated on the undercoat layer was visually observed, and the number of reciprocating frictions until scratches were generated was measured and taken as the number of durability N.

[Coefficient of dynamic friction when front and back of gas barrier film are superimposed]

**[0118]** The measurement of the coefficient of dynamic friction was performed based on JIS K7125 (weight: 201 g, speed: 100 mm/mim).

[Pencil hardness of outermost surface of gas barrier film]

**[0119]** The evaluation was performed using a pencil hardness tester (YASUDA SEIKI SEISAKUSHO, LTD.) in conformity with JIS K5600.

[Flexibility (number of bending resistance) of gas barrier film]

**[0120]** Flexibility was evaluated using a U-shaped folding tester DLDM111LH manufactured by YUASA SYSTEM Co., Ltd. Specifically, the measurement was performed at a bending radius of 5 mm and a reciprocating speed of 30 rmp/min with the side of the inorganic thin film layer laminated on the undercoat layer as an inner side, and the number of reciprocations until the gas barrier film cracked was measured and taken as the number of bending resistance. Incidentally, it can be said that the flexibility is superior as the number of bending resistance is greater.

[Optical properties of gas barrier film]

(Total light transmittance)

**[0121]** The total light transmittance through the gas barrier film was measured using a direct reading haze computer (Model HGM-2DP) manufactured by Suga Test Instruments Co., Ltd.. The background measurement was performed in a state in which the sample was not set, then the gas barrier film was set on the sample holder, and the measurement was performed to determine the total light transmittance.

(Haze)

**[0122]** The haze of laminated film was measured using a direct reading haze computer (Model HGM-2DP) manufactured by Suga Test Instruments Co., Ltd.. The background measurement was performed in a state in which the sample was not set, then the laminated film was set in the sample holder, and the measurement was performed to determine the haze.

(Yellowness)

**[0123]** The yellowness (b*) of the laminated film was measured using one sheet of film sample and a spectrophotometer (CM3700d, manufactured by KONICA MINOLTA JAPAN, INC.) in conformity with ASTM E313.

(Reaction rate in undercoat layer)

**[0124]** The reaction rate of the coating agent was measured on the coating film surface side before and after curing after the coating liquid was applied and dried in each step using a Fourier transform type infrared spectrophotometer (FT/IR-460Plus manufactured by JASCO Corporation) equipped with an ATR attachment (PIKE MIRacle), and the area

ratio between the peak attributed to a carbonyl group C=O (1,700 cm$^{-1}$) and the peak attributed to an acrylate group C=C-C=O (1,400 cm$^{-1}$) was calculated.

$$\text{Reaction rate [\%]} = [1 - (Sa1,400/Sa1,700)/(Sb1,400/Sb1,700)$$

[$I_b/I_a$ in undercoat layer]

The infrared absorption measurement of the undercoat layer can be performed using a Fourier transform type infrared spectrophotometer (FT/IR-460Plus manufactured by JASCO Corporation) equipped with an ATR attachment (PIKE MIRacle) using germanium crystal as prism.

[X-ray photoelectron spectroscopic measurement of inorganic thin film layer surface]

The ratio of the number of atoms in the inorganic thin film layer surface of the gas barrier film was measured by X-ray photoelectron spectroscopy (Quantera SXM manufactured by ULVAC-PHI, INCORPORATED). AlK$\alpha$ ray (1486.6 eV, X-ray spot: 100 $\mu$m) was used as an X-ray source, and a neutralizing electron gun (1 eV) and a low-speed Ar ion gun (10 V) were used for charge correction at the time of measurement. As the analysis after measurement, spectrum analysis was performed using MultiPakV6.1A (ULVAC-PHI, INCORPORATED) and the ratio of the number of C to the number of Si in the surface was calculated using the peaks corresponding to the binding energies of 2p of Si, 1s of O, 1s of N, and 1s of C attained from the measured wide scan spectrum. As the ratio of the numbers of surface atoms, an average value of values attained through five times of measurement was adopted.

[Infrared spectroscopic measurement (ATR method) of inorganic thin film layer surface]

The infrared spectroscopic measurement of the inorganic thin film layer surface of the gas barrier film was performed using a Fourier transform type infrared spectrophotometer (FT/IR-460Plus manufactured by JASCO Corporation) equipped with an ATR attachment (PIKE MIRacle) using germanium crystal as prism.

[Method for manufacturing inorganic thin film layer]

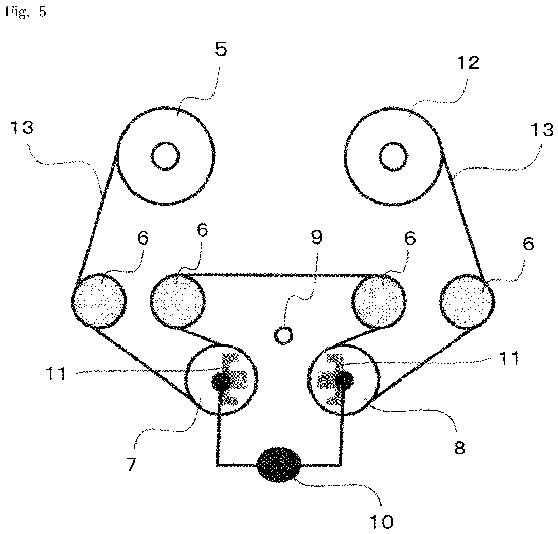

An inorganic thin film layer was laminated on a substrate layer or on an undercoat layer laminated on the substrate layer using the manufacturing apparatus illustrated in Fig. 5. Specifically, as illustrated in Fig. 5, a resin film substrate including an undercoat layer was mounted on a delivery roll 5, the pressure in the vacuum chamber was reduced to 1 × 10$^{-3}$ Pa or less, and then an inorganic thin film layer was deposited on the resin film substrate. In a plasma CVD apparatus used to form an inorganic thin film layer, the resin film substrate is transported while being in close contact with each of the surfaces of a pair of roll-shaped electrodes, plasma is generated between the pair of electrodes, and the raw material is decomposed in the plasma to form an inorganic thin film layer on the resin film substrate.
Magnets are disposed inside the pair of electrodes so that the magnetic flux density is higher on the electrodes and the resin film substrate surface, and the plasma is constrained on the electrodes and the resin film substrate at a high density when the plasma is generated. Upon the deposition of inorganic thin film layer, hexamethyldisiloxane (HMDSO) gas and oxygen gas were introduced into the space between the electrodes (deposition roll 7 and deposition roll 8) to be a deposition zone, and an alternating-current was supplied to between the electrode rolls to discharge electricity and generate plasma. Subsequently, the air volume displacement was adjusted so that the pressure in the vicinity of the air outlet in the vacuum chamber became 1 Pa, and then a dense inorganic thin film layer was formed on the resin film substrate by a plasma CVD method.

<Deposition condition 1>

Amount of source gas supplied: 50 sccm (Standard Cubic Centimeter per Minute, based on 0°C and 1 atm)
Amount of oxygen gas supplied: 500 sccm
Degree of vacuum in vacuum chamber: 1 Pa
Applied power from power supply for plasma generation: 0.4 kW
Frequency of power supply for plasma generation: 70 kHz
Transport velocity of film; 3.0 m/min
Number of passes: 28 times

[Adhesive property after reliability test]

The adhesive property was measured in conformity with ASTM D3359 using the gas barrier film after being subjected to a reliability test as a measurement sample. Specifically, a gas barrier film of 5 cm × 5 cm was subjected to a reliability test by being left to stand in an environment at 60°C and a humidity of 90% for 250 hours, and the film after being subjected to the test was subjected to a cross-cut test under the following conditions to evaluate the adhesive property. As the cross-cut test, the gas barrier film is placed on a clean glass substrate so that the surface on the side of the inorganic thin film layer laminated on the undercoat layer of the gas barrier film is on the opposite side to the glass substrate, and 10 × 10 (100 squares) cuts which reach the substrate layer are made on the inorganic thin film layer laminated on the undercoat layer using a cutter guide and a cutter knife. A tape (CELLOTAPE (registered trademark) CT-12M manufactured by NICHIBAN Co., Ltd.) is flatly stuck to the lattice portion (cross-cut portion) by the cuts so that air bubbles and the like do not enter the range of the lattice portion + 20 mm. The stuck tape was peeled off at an angle of 60° for 0.5 to 1 second, and the state of the lattice portion was observed under a microscope (for example, DIGITAL MICROSCOPE KH7700 manufactured by HIROX CO., LTD.), and the number of squares which were not peeled off but remained was counted. It can be said that the adhesive property is higher as the number of squares which have not been peeled off but have remained is greater.

[Preparation of coating composition]

In Examples and Comparative Examples to be described later, compositions containing a photocurable compound having a polymerizable functional group (hereinafter, referred to as "coating agent compositions") were used to form an undercoat layer.

(Coating agent composition 1)

TOMAX FA-3292 manufactured by NIPPON KAKO TORYO CO., LTD. was used as a coating composition 1. The coating composition 1 is a composition containing ethyl acetate as a solvent at 8.1% by weight, propylene glycol monomethyl ether at 52.1% by weight, a UV curable oligomer as a solid component at 10% to 20% by weight, silica at 20% to 30% by weight, and a photoinitiator as an additive.

(Coating agent composition 2)

ARONIX UV-3701 manufactured by TOAGOSEI CO., LTD. was used as a coating composition 2. The coating composition 2 is a composition containing special acrylates at about 80% by weight, N-vinyl-2-hyrolidone at 17% to 18% by weight, and a leveling agent and a photoinitiator as additives, respectively at about 2%.

[Example 1]

The coating agent composition 1 (TOMAX FA-3292 manufactured by NIPPON KAKO TORYO CO., LTD.) was applied to one surface of a cycloolefin polymer film (COP film, thickness: 50 μm, width: 350 mm, trade name "ZEONOR Film (registered trademark) ZF-16" manufactured by ZEON CORPORATION) which was a flexible substrate by a gravure coating method, dried at 100°C for 1 minute, and then irradiated with ultraviolet light under a condition of an integrated quantity of light of 500 mJ/cm$^2$ using a high-pressure mercury lamp to laminate an organic layer A1 (undercoat) having a reaction rate of 80% and a thickness of 1.5 μm, thereby obtaining a laminated film to be a substrate layer. An inorganic thin film layer was laminated on the surface on the organic layer A1 side of the laminated film thus obtained by the method for manufacturing an inorganic thin film layer to obtain a gas barrier film 1.

The gas barrier film obtained in Example 1 was a film having a layer configuration of substrate layer/undercoat layer (flattening layer)/inorganic thin film layer, and the coefficient of dynamic friction between the outermost surfaces when the front and back of the gas barrier film were superimposed one on top of the other was 0.30.

In the gas barrier film obtained, the ratio of the number of oxygen, the ratio of the number of silicon, and the ratio of the number of carbon increased in this order in 90% or more of the region in the film thickness direction of the inorganic thin film layer, the carbon distribution curve in the film thickness direction had 100 or more extreme values, and the absolute value of the difference between the maximum value and minimum value of the ratio of the number of carbon in the carbon distribution curve was 5% or more.

In addition, XPS depth profile measurement was performed, the average atomic concentration of each atom in the thickness direction was determined from the distribution curves of silicon atom, oxygen atom, and carbon atom attained, then the average ratios of the numbers of atoms C/Si and O/Si were calculated, and as a result, the average ratios of the numbers of atoms were C/Si = 0.30 and O/Si = 1.73. In addition, the ratio of the number of carbon atoms to the total number of silicon atoms, oxygen atoms, and carbon atoms contained in the inorganic thin film layer was continuously changed in the film thickness direction of the inorganic thin film layer.

<XPS depth profile measurement>

Etching ion species: Argon ($Ar^+$)
Etching rate ($SiO_2$ thermal oxide film equivalent): 0.027 nm/sec
Sputtering time: 0.5 min
X-ray photoelectron spectrometer: Quantera SXM manufactured by ULVAC-PHI, INCORPORATED.
Irradiation X-ray: Single crystal spectroscopy AlK$\alpha$ (1,486.6 eV)
X-ray spot and size: 100 $\mu$m
Detector: Pass Energy 69eV, Step size 0.125eV
Charge correction: Neutralizing electron gun (1 eV), Low-speed Ar ion gun (10 V)
The inorganic thin film layer of the gas barrier film obtained was subjected to the infrared spectroscopic measurement under the conditions described above. The absorption intensity ratio ($I_2/I_1$) of the peak intensity ($I_1$) present at 950 to 1,050 $cm^{-1}$ to the peak intensity ($I_2$) present at 1,240 to 1,290 $cm^{-1}$ was determined from the infrared absorption spectrum attained and found that $I_2/I_1$ = 0.03. In addition, the absorption intensity ratio ($I_3/I_1$) of the peak intensity ($I_1$) present at 950 to 1,050 $cm^{-1}$ to the peak intensity ($I_3$) present at 770 to 830 $cm^{-1}$ was determined from the infrared absorption spectrum attained and found that $I_3/I_1$ = 0.36. In addition, the absorption intensity ratio ($I_4/I_3$) of the peak intensity ($I_3$) present at 770 to 830 $cm^{-1}$ to the peak intensity ($I_4$) present at 870 to 910 $cm^{-1}$ was determined and found that $I_4/I_3$ = 0.84.
The thickness of the substrate layer in the gas barrier film obtained was 52 $\mu$m, the thickness of the undercoat layer was 1.5 $\mu$m, and the thickness of the inorganic thin film layer was 0.5 $\mu$m.

[Example 2]

A gas barrier film 2 was obtained in the same manner as in Example 1 except that the coating agent composition 1 (TOMAX FA-3292 manufactured by NIPPON KAKO TORYO CO., LTD.) was irradiated with ultraviolet light under a condition of an integrated quantity of light of 800 mJ/cm² and the reaction rate was 90% in Example 1.
The gas barrier film obtained in Example 2 was a film having a layer configuration of substrate layer/undercoat layer (flattening layer)/inorganic thin film layer, and the coefficient of dynamic friction between the outermost surfaces when the front and back of the gas barrier film were superimposed one on top of the other was 0.25.

[Example 3]

A laminated film to be a substrate layer was obtained in the same manner as in Example 1 except that the coating agent composition 1 (TOMAX FA-3292 manufactured by NIPPON KAKO TORYO CO., LTD.) was irradiated with ultraviolet light under a condition of an integrated quantity of light of 350 mJ/cm² and the reaction rate was 75% in Example 1. An inorganic thin film layer was laminated on the surface (substrate surface) which was not coated on the organic layer A1 side of the laminated film thus obtained by the method for manufacturing an inorganic thin film layer to obtain a gas barrier film 3.
The gas barrier film obtained in Example 3 was a film having a layer configuration of inorganic thin film layer/substrate layer/undercoat layer (flattening layer)/inorganic thin film layer, and the coefficient of dynamic friction between the outermost surfaces when the front and back of the gas barrier film were superimposed one on top of the other was 0.35.

[Comparative Example 1]

The coating agent composition 2 (ARONIX UV-3701 manufactured by TOAGOSEI CO., LTD.) was applied to one surface of a cycloolefin polymer film (COP film, thickness: 50 $\mu$m, width: 350 mm, trade name "ZEONOR Film (registered trademark) ZF-16" manufactured by ZEON CORPORATION) which was a flexible substrate by a gravure coating method, dried at 100°C for 1 minute, and then irradiated with ultraviolet light under a condition of an integrated quantity of light of 300 mJ/cm² using a high-pressure mercury lamp to laminate an organic layer A2 (flattening layer) having a reaction rate of 80% and a thickness of 1.5 $\mu$m, thereby obtaining a laminated film to be a substrate layer. An inorganic thin film layer was laminated on the surface on the organic layer A2 side of the laminated film thus obtained and the surface (substrate surface) which was not coated by the method for manufacturing an inorganic thin film layer to obtain a gas barrier film 4.
The gas barrier film obtained in Comparative Example 1 was a film having a layer configuration of inorganic thin film layer/substrate layer/undercoat layer (flattening layer)/inorganic thin film layer, and the coefficient of dynamic friction between the outermost surfaces when the front and back of the gas barrier film were superimposed one on top of the other was 0.60.

[Comparative Example 2]

A gas barrier film 5 was obtained in the same manner as in Comparative Example 1 except that the coating agent composition 2 (ARONIX UV-3701 manufactured by TOAGOSEI CO., LTD.) was irradiated with ultraviolet light under a condition of an integrated quantity of light of 150 mJ/cm$^2$ and the reaction rate was 50% in Comparative Example 1.

The gas barrier film obtained in Comparative Example 2 was a film having a layer configuration of inorganic thin film layer/substrate layer/undercoat layer (flattening layer)/inorganic thin film layer, and the coefficient of dynamic friction between the outermost surfaces when the front and back of the gas barrier film were superimposed one on top of the other was 0.80.

The gas barrier films of Examples and Comparative Examples obtained as described above were subjected to the measurement of water vapor transmission rate, number of durability N, pencil hardness, and flexibility by the measurement methods described above. In addition, $I_b/I_a$ in the undercoat layer was also measured. The results attained are presented in Table 1. Incidentally, the UC side in Table 1 means the surface on the side on which the undercoat layer is laminated with respect to the substrate layer among the outermost surfaces of the gas barrier film and the opposite side means the surface on the opposite side to the side on which the undercoat layer is laminated with respect to the substrate layer.

[Table 1]

| | | Number of durability N [times] | $I_b / I_a$ | Pencil hardness (UC side/ opposite side) | Water vapor transmission rate [g/m$^2$/day] | Number of bending resistance |
|---|---|---|---|---|---|---|
| Example | 1 | 70 | 0.28 | HB/B | < 1 × 10$^{-5}$ | > 100,000 times |
| | 2 | 120 | 0.31 | F/B | < 1 × 10$^{-5}$ | > 100,000 times |
| | 3 | 40 | 0.22 | HB/B | < 1 × 10$^{-5}$ | > 100,000 times |
| Comparative Example | 1 | 250 | 1.28 | F/B | < 1 × 10$^{-5}$ | < 10,000 times |
| | 2 | 10 | 0.78 | B/B | > 1 × 10$^{-3}$ | < 20,000 times |

The optical properties of the gas barrier films obtained in Examples and Comparative Examples above were measured by the measurement methods described above. In addition, a reliability test was performed by the method described above, and the adhesive property and optical properties of the films after the test were measured. The results attained are presented in Table 2.

[Table 2]

| | | Before reliability test | | | After reliability test | | | |
|---|---|---|---|---|---|---|---|---|
| | | Tt [%] | Haze [%] | b* | Tt | Haze | b* | Adhesive property |
| Example | 1 | 91 | 0.5 | 2.1 | 91 | 0.5 | 2.1 | 100/100 |
| | 2 | 91 | 0.6 | 2.2 | 91 | 0.6 | 2.2 | 100/100 |
| | 3 | 91 | 0.5 | 2.1 | 91 | 0.5 | 2.1 | 100/100 |
| Comparative Example | 1 | 91 | 0.5 | 2.3 | 91 | 0.5 | 2.3 | 0/100 |
| | 2 | 91 | 0.8 | 2.1 | 90 | 1.6 | 2.1 | 20/100 |

DESCRIPTION OF REFERENCE SIGNS

1... Gas barrier film
2... Substrate layer
3... Undercoat layer
4... Inorganic thin film layer
5... Delivery roll
6... Transport roll
7... Deposition roll
8... Deposition roll
9... Gas supply pipe
10... Power supply for plasma generation
11... Magnetic field generator
12... Wind-up roll
13... Film

**Claims**

1.  A gas barrier film comprising at least a substrate layer including at least a flexible substrate, an undercoat layer, and an inorganic thin film layer in this order,
    wherein
    a water vapor transmission rate through the gas barrier film at 23°C and 50% RH is 0.001 g/m$^2$/day or less, and a number of durability N measured by performing a steel wool test of an outermost surface on an inorganic thin film layer side of the gas barrier film using #0000 steel wool under conditions of a load of 50 gf/cm$^2$, a speed of 60 rpm/min, and a one-way distance of 3 cm satisfies Formula (1):

$$N \leq 200 \quad (1).$$

2.  The gas barrier film according to claim 1, wherein the undercoat layer contains a polymer of a photocurable compound having a polymerizable functional group.

3.  The gas barrier film according to claim 1 or 2, wherein a coefficient of dynamic friction between one outermost surface and the other outermost surface of the gas barrier film is 0.5 or less.

4.  The gas barrier film according to any one of claims 1 to 3, wherein $I_a$ and $I_b$ satisfy Formula (2):

$$0.05 \leq I_b/I_a \leq 1.0 \quad (2),$$

    where $I_a$ denotes an intensity of an infrared absorption peak in a range of 1,000 to 1,100 cm$^{-1}$ in an infrared absorption spectrum of the undercoat layer and $I_b$ denotes an intensity of an infrared absorption peak in a range of 1,700 to 1,800 cm$^{-1}$.

5.  The gas barrier film according to any one of claims 1 to 4, wherein the inorganic thin film layer contains at least a silicon atom, an oxygen atom, and a carbon atom.

6.  The gas barrier film according to claim 5, wherein a ratio of a number of carbon atom to a total number of silicon atom, oxygen atom, and carbon atom contained in the inorganic thin film layer continuously changes in 90% or more of region in a film thickness direction of the inorganic thin film layer.

7.  The gas barrier film according to claim 5 or 6, wherein a carbon distribution curve indicating relationship between a distance from a surface of the inorganic thin film layer in the film thickness direction of the inorganic thin film layer and a ratio of a number of carbon atom to a total number of silicon atom, oxygen atom, and carbon atom contained in the inorganic thin film layer at each distance has eight or more extreme values.

8. The gas barrier film according to any one of claims 1 to 7, comprising a protective thin film layer on the inorganic thin film layer,
   wherein the protective thin film layer is fabricated by subjecting a coating film obtained from a coating liquid containing a silicon compound to a modification treatment.

9. A flexible electronic device comprising the gas barrier film according to any one of claims 1 to 8.

Fig. 1

1

2

3

4

Fig. 2

1

4

3

2

4

Fig. 3

Fig. 4

Fig. 5

## INTERNATIONAL SEARCH REPORT

| International application No. |
|---|
| PCT/JP2018/033393 |

**A. CLASSIFICATION OF SUBJECT MATTER**
Int.Cl. B32B9/00(2006.01)i

According to International Patent Classification (IPC) or to both national classification and IPC

**B. FIELDS SEARCHED**

Minimum documentation searched (classification system followed by classification symbols)
Int.Cl. B32B1/00-43/00, H05B33/04

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2014/163062 A1 (KONICA MINOLTA, INC.) 09 October 2014, claims, paragraphs [0028]-[0032], [0044]-[0045], [0053]-[0058], [0064]-[0065], [0083]-[0085], [0099], [0148], tables 1, 2, examples 15-25 & US 2016/0049609 A1, claims, paragraphs [0026]-[0030], [0047]-[0048], [0064]-[0069], [0090]-[0092], [0109], [0158], tables 1, 2, examples 15-25 | 1-9 |

☒ Further documents are listed in the continuation of Box C.  ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 21 November 2018 (21.11.2018) | 04 December 2018 (04.12.2018) |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

| International application No. |
|---|
| PCT/JP2018/033393 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2012-20409 A (FUJIFILM CORP.) 02 February 2012, claims, paragraphs [0002], [0004], [0019]-[0022], [0039]-[0045] (Family: none) | 1-9 |
| A | JP 2016-155241 A (JNC CORPORATION) 01 September 2016, claims, paragraphs [0007]-[0009], [0026]-[0027], [0050]-[0056], table 1, paragraph [0076] (Family: none) | 1-9 |
| A | JP 2016-68383 A (SUMITOMO CHEMICAL CO., LTD.) 09 May 2016, claims, paragraphs [0005]-[0006], [0016], [0020], [0032]-[0033], example 1, fig. 1 & US 2017/0268929 A1, claims, paragraphs [0005]-[0006], [0022], [0033]-[0037], example 1, fig. 1 & WO 2016/052369 A1 & CN 106715116 A & KR 10-2017-0063584 A | 1-9 |
| P, A | WO 2018/100963 A1 (FUJIFILM CORP.) 07 June 2018, claims, paragraphs [0011], [0026]-[0028], [0030]-[0031], [0170]-[0171], example 16 (Family: none) | 1-9 |

Form PCT/ISA/210 (continuation of second sheet) (January 2015)

27

**EP 3 683 049 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014083690 A
- WO 2016043141 A
- JP 2016068383 A

28